# EUROPÄISCHE PATENTANMELDUNG

(11) **EP 3 878 986 A1**
(43) Veröffentlichungstag der Anmeldung: **15.09.2021**
(21) Anmeldenummer: 20162608.2
(22) Anmeldetag: 12.03.2020
(51) Int. Cl.: C22C 1/04, C22C 1/05, C22C 5/04, C22C 9/00, G01R 1/067, G01R 3/00, C22C 21/00

(54) **DRAHT UND BAND MIT BORNITRID-NANORÖHREN FÜR ELEKTRISCHE KONTAKTIERUNGEN**

(71) Anmelder: Heraeus Deutschland GmbH & Co KG, 63450 Hanau (DE)
(72) Erfinder: WEGNER, Dr. Matthias, 63450 Hanau (DE); FECHER, Dr. Jonas, 63450 Hanau (DE); SCHUSTER, Jochen, 63450 Hanau (DE)
(74) Vertreter: Schultheiss & Sterzel Patentanwälte PartG mbB

(57) **Zusammenfassung**

Die Erfindung betrifft einen Draht (1) oder ein Band zur Herstellung von Prüfnadeln oder Schleifkontakten, der Draht (1) oder das Band aufweisend ein Material oder bestehend aus einem Material, das Material aufweisend eine Matrix aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen, wobei die Matrix eine zusammenhängende metallisch leitfähige Struktur in dem Material bildet, wobei die Bornitrid-Nanoröhren in der Matrix enthalten sind, wobei die Bornitrid-Nanoröhren ein festes Gefüge mit der Matrix bilden.

Die Erfindung betrifft auch ein Verfahren zur Herstellung eines Drahts (1) oder eines Bands sowie eine Prüfnadel, einen Schleifdraht, einen Schleifkontakt und ein Prüfnadelarray aufweisend zumindest ein Teilstück eines solchen Drahts (1) oder Bands.

## Beschreibung

Die Erfindung betrifft einen Draht und ein Band zur Herstellung von Prüfnadeln zur Prüfung der elektrischen Kontaktierung von Anschlusspads oder zur Herstellung von Schleifdrähten für Schleifkontakte wie Vieldrahtschleifer und Büschelbürsten sowie ein Verfahren zur Herstellung eines solchen Drahts und eines solchen Bands.

Die Erfindung betrifft auch eine Prüfnadel, ein Prüfnadelarray, einen Schleifdraht und einen Schleifkontakt aufweisend zumindest einen solchen Draht oder ein solches Band beziehungsweise Teilstücke eines solchen Drahts oder eines solchen Bands.

Drähte und Bänder beziehungsweise Teilstücke davon können als Prüfnadeln zur Prüfung der elektrischen Kontaktierung von Anschlüssen in der Mikroelektronik oder als Schleifdrähte zur Herstellung von elektrischen Schleifkontakten eingesetzt werden.

Während der Chipproduktion werden Wafer direkt nach der Prozessierung mit Prüfnadeln kontaktiert, um die Funktionsfähigkeit von integrierten Schaltungen (IC) in ungesägtem Zustand zu testen. Ein Array von Prüfnadeln testet dabei nach der Strukturierung der einzelnen Chips den Halbleiterwafer auf Funktionalität. Die Prüfnadeln sind in einer Testkarte (probe card) fixiert, die auf das Design des Wafers abgestimmt ist. Beim Prüfprozess wird der Wafer auf die Prüfnadeln gepresst und eine Kontaktierung zwischen Prüfnadeln und den Pads der ICs hergestellt, bei Aluminium Pads durch eine Passivierungsschicht hindurch hergestellt. Daraufhin werden verschiedene Parameter getestet, wie zum Beispiel die Kontaktierung, elektrische Kennwerte bei hoher Stromdichte und das elektrische Verhalten bei Temperaturwechseln.

Prüfnadeln werden also bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1).

Die Schlüsselparamater einer guten Prüfnadel sind eine hohe elektrische Leitfähigkeit, da hierbei hohe elektrische Ströme übertragen werden müssen, sowie ein passendes E-Modul (m_{E}) und eine hohe Streckgrenze (Rp_{0,2}), welche gute Federeigenschaften hervorrufen. Eine hohe thermische Leitfähigkeit bewirkt eine gute Abfuhr der Wärmeenergie und damit eine möglichst geringe zusätzliche thermische Erhöhung des elektrischen Widerstands. Geeignete Härte, E-Modul und Streckgrenze werden benötigt, um zum einen die Wartungsintervalle gering zu halten und zum anderen um gute Federeigenschaften der Prüfnadel zu realisieren.

Für das Testen auf Aluminiumpads sind Prüfnadeln aus den Materialien Wolfram, Wolframcarbid, Palladium-Kupfer-Silber-Legierungen und Wolfram-Rhenium weit verbreitet. Diese sind besonders hart, wobei Aluminiumpads robuster als Goldpads sind und einer Prüfung mit harten Nadeln besser standhalten können als Goldpads.

Für die Anwendung auf Goldpads sind Pd-Legierungen bekannt, wie beispielsweise Paliney® H3C der Firma Deringer Ney oder NewTec® der Firma Advanced Probing. Weiterhin existieren PtNi30-Legierungen für Prüfnadeln im Markt. Aus der US 2010/0239453 A1 und der EP 2 248 920 A1 sind niedrig dotierte Iridium-Legierungen zur Herstellung von Prüfnadeln bekannt.

Die US 2006/0197542 A1 offenbart eine Iridium-Basislegierung und eine Platin-Basislegierung zum Herstellen von Prüfnadeln. Die Legierungen weisen eine hohe Härte zwischen 300 HV und 500 HV auf, um einen guten Kontakt durch eine auf den Goldpads angeordnete Lackschicht herstellen zu können.

Iridium hat den Nachteil, dass es eine geringere Wärmeleitfähigkeit und elektrische Leitfähigkeit als andere Metalle hat.

Nachteilig ist bei diesen Legierungen auch, dass die Spitzen angeschliffen werden müssen, was ein teurer und häufig manuell durchgeführter Prozess ist.

Weiterhin können Prüfstrukturen in geringem Umfang mikrosystemtechnisch hergestellt werden. Nachteilig sind dabei die hohen Herstellungskosten.

Aktuell werden für sogenannte "Probe Needles" (Prüfnadeln) Metalle oder Legierungen verwendet, die eine hohe elektrische und thermische Leitfähigkeit aber auch hohe Härten und Zugfestigkeiten besitzen. Dabei dient die elektrische Leitfähigkeit von reinem Kuper (100% IACS) als Referenz. Kupfer (Cu) und Silber (Ag) können zu diesen Zwecken jedoch nicht eingesetzt werden, da sie deutlich zu weich sind und sich die Prüfnadel beim Einsatz verformen würde. Typische Materialien für Prüfnadeln sind ausscheidungshärtende Legierung wie CuAg7 mit 7 Gew% Silber und dem Rest Kupfer einschließlich herstellungsbedingter Verunreinigungen sowie ausscheidungsgehärtete Palladium-Silber-Legierungen, die 10% Gold und 10% Platin enthalten und beispielsweise unter den Produktnamen Paliney® 7 und Hera 648 vertrieben werden. Als Materialien für Folien zur Herstellung von Prüfnadeln werden aber auch PtNi-Legierungen (Platin-Nickel-Legierungen) oder Rhodium (Rh) verwendet. Bei solchen Metallen oder Legierungen, die einen möglichst guten Kompromiss zwischen elektrischer Leitfähigkeit, thermischer Leitfähigkeit, Zugfestigkeit sowie Härte darstellen, beträgt die maximal mögliche elektrische Leitfähigkeit 5% bis 30% IACS.

Typische Materialien für Probing-Anwendungen sind unter anderem auch Rhodium und seine Legierungen. Da Rhodium in reiner Form ein verhältnismäßig hohes E-Modul hat (ca. 370 GPa), ist es jedoch nur bedingt einsetzbar. Diese Einschränkung bewirkt, dass Prüfnadeln aus diesen Materialien nur mit dünnsten Durchmessern und extrem verlängerte Prüfnadeln verwendbar sind, um das E-Modul beziehungsweise die daraus folgende notwendige mechanische Kraft beziehungsweise, Spannung zu kompensieren. Die längere Nadel hat jedoch zur Folge, dass der elektrische Widerstand der Prüfnadel stark steigt, was unvorteilhaft ist. Gleichzeitig haben Rhodium und seine Legierungen üblicherweise ohnehin nur geringe elektrische Leitfähigkeiten von nur etwa 30% IACS. Ferner wird die Wärmeableitung durch eine dünne und lange Prüfnadel verschlechtert.

Neben Prüfnadeln profitieren aber auch andere Anwendungen, wie insbesondere Drähte für Schleifkontakte, von Materialien mit hohen elektrischen und thermischen Leitfähigkeiten und gleichzeitig guten mechanischen Eigenschaften, wie einer hohen Härte und Zugfestigkeit. Bei Schleifkontakten ist es wichtig, dass einerseits durch die Oberflächen ein geringer Übergangswiderstand verursacht wird und andererseits das Material sich nicht zu schnell abnutzt also abreibt oder erodiert.

Anwendungen wie Prüfnadeln (Probe Needles) oder Schleifdrähte in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung.

Die WO 2016/009293 A1 schlägt eine Prüfnadel vor, wobei an der Vorderseite der Prüfnadel eine Spitze angeordnet ist, die aus einem mechanisch harten ersten Material besteht und der Rest der Prüfnadel aus einem zweiten Material mit einer hohen elektrischen Leitfähigkeit besteht. Ähnliche Prüfnadeln sind auch aus der US 2013/0099813 A1, der EP 2 060 921 A1 und der US 2012/0286816 A1 bekannt. Mit der US 2019/0101569 A1 wird ein Manteldraht mit einer solchen Spitze vorgeschlagen, wobei die Spitze nur an der Drahtseele des Manteldrahts befestigt wird. Nachteilig ist hieran, dass die Prüfnadel über ihre Länge keine homogenen physikalischen Eigenschaften mehr hat und dass die elektrische und thermische Leitfähigkeit aber auch die Zugfestigkeit sehr stark von der Verbindung zwischen den beiden Materialien abhängt. Zudem lässt sich eine niedrige elektrische Leitfähigkeit in einem Bereich nicht einfach durch eine hohe elektrische Leitfähigkeit in einem anderen Bereich ausgleichen, da der Strom wie bei Reihenschaltungen von elektrischen Widerständen beide Bereiche passieren muss. Ein beschichteter Metallstreifen mit Bornitrid-Partikeln zur Stabilisierung ist aus der WO 03/104532 A1 bekannt.

Als Verbunddrähte zur Herstellung von Prüfnadeln oder Schleifdrähten können beispielsweise rundumbeschichtete Drähte eingesetzt werden, die als sogenannte Manteldrähte oder Double-Drähte durch endlos Walzprozesse oder mit Hilfe von galvanischen Beschichtungen hergestellt werden können. Beispielsweise können diese im Inneren ein Unedel-Metall, beispielsweise aus einer Cu-Legierung wie CuBe₂ aufweisen, ummantelt mit einer Edelmetall- Legierung (beispielsweise Hera238), um für kontakttechnische Anwendungen bei gleitenden Kontakten in Schleifringübertragern oder auch Schaltkontakten in Mikroschaltern eingesetzt werden zu können, so wie dies in der nicht vorveröffentlichten DE 10 2019 130 522.5 beschrieben ist.

Die Verstärkung von Materialien mit Kohlenstoff-Nanoröhren (CNT - Carbon Nano Tubes) und Bornitrid-Nanoröhren (BNNT - Boron-Nitrid Nano Tubes) ist bekannt. Diese werden meist zur reinen mechanischen Verstärkung von Materialien wie Kupfer, Aluminium und Titan eingebracht (siehe hierzu beispielsweise die DE 10 2008 056 750 A1, die US 7988367 B2, die WO 2008/050099 A1). Aus der WO 2018/126191 A1 ist ein Verfahren zur Benetzung von Kohlenstoff-Nanoröhren und Bornitrid-Nanoröhren mit einer Metallschmelze zur Herstellung eines Verbunds bekannt. Nachteilig ist hieran der hohe Kostenaufwand und die hierfür notwendige aufwendige Fertigungsanlage. Zudem können Metalle und Legierungen mit hohem Schmelzpunkt die Struktur der Bornitrid-Nanoröhren beschädigen und damit den stabilisierenden Effekt im Verbundwerkstoff verschlechtern. Die US 2019/0198418 A1 offenbart eine Materialschicht enthaltend ausgerichtete Bornitrid-Nanoröhren zur Wärmeableitung. Für elektrische Kontaktanwendungen ist das Material nicht vorgesehen und nicht geeignet, da der elektrische Widerstand aufgrund der dicht gepackten Bornitrid-Nanoröhren viel zu hoch ist und das Material nicht homogen ist.

Die Aufgabe der Erfindung besteht also darin, die Nachteile des Stands der Technik zu überwinden. Insbesondere sollen ein Draht oder ein Band als Halbzeuge zur Fertigung von Prüfnadeln und Schleifdrähten und ein Verfahren zu deren Herstellung gefunden werden, aus denen Prüfnadeln und Schleifdrähte herstellbar sind, die eine möglichst hohe Wärmeleitfähigkeit und elektrische Leitfähigkeit aufweisen und gleichzeitig die für Prüfnadeln geeigneten mechanischen Eigenschaften bezüglich des E-Moduls und der Federeigenschaften aufweisen. Gleichzeitig muss die Wärmeleitung dazu ausreichen, die durch die Kontaktströme entstehende Wärme aus den Prüfnadeln und die durch die Kontaktströme und die durch die Reibung entstehende Wärme aus den Schleifdrähten abzuleiten, damit der Temperatur-abhängige Widerstand in den Prüfnadeln und Schleifdrähten nicht zu stark ansteigt und damit die Messungen mit Hilfe der Prüfnadeln nicht zu stark verfälscht beziehungsweise der Leistungsverlust in dem Schleifkontakt nicht zu groß wird.

Ferner sollen der Draht, das Band und die mit dem Verfahren hergestellten Drähte und Bänder eine ausreichend hohe Härte aufweisen, um möglichst eine lange Standzeit und nur eine geringe oder keine Beschädigungen der Pads zu garantieren. Gleichzeitig sollen die Materialien eine ausreichende Elastizität besitzen, damit sich die Prüfnadeln nicht bei der Kontaktierung plastisch verformen und um die Toleranzen beim Herstellen von Testkarten mit solchen Prüfnadeln möglichst groß zu halten. Des Weiteren sollen der Draht und das Band möglichst kostengünstig zu fertigen sein. Neben dem Band und dem Draht und dem Verfahren sollen auch aus solchen Drähten und Bändern gefertigte Prüfnadeln, Schleifdrähte, Schleifkontakte und Prüfnadelarrays gefunden werden, die über die genannten vorteilhaften Kombinationen von physikalischen Eigenschaften verfügen.

Die der vorliegenden Erfindung zugrundeliegenden Aufgaben werden gelöst durch einen Draht oder ein Band zur Herstellung von Prüfnadeln oder Schleifkontakten, der Draht oder das Band aufweisend ein Material oder bestehend aus einem Material, das Material aufweisend eine Matrix aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen, wobei die Matrix eine zusammenhängende metallisch leitfähige Struktur in dem Material bildet, wobei die Bornitrid-Nanoröhren in der Matrix enthalten sind und wobei die Bornitrid-Nanoröhren ein festes Gefüge mit der Matrix bilden.

Unter einer Basis-Legierung wird eine Legierung verstanden, bei der die Legierung einen Anteil von zumindest 50 at% des angegebenen Elements beziehungsweise Metalls enthält. Eine Kupfer-Basis-Legierung besteht demzufolge zumindest zu 50% aus Kupfer.

Dass die Bornitrid-Nanoröhren ein festes Gefüge mit der Matrix bilden bedeutet, dass diese nicht lose in der Matrix und dort beweglich gegen die Matrix angeordnet sind. Vorzugsweise sind die Bornitrid-Nanoröhren fest mit der sie umgebenden Matrix verbunden. Die Bindung kann dabei besonders bevorzugt über Van-der-Waals-Wechselwirkungen erfolgen.

Es kann vorgesehen sein, dass der Draht oder das Band neben dem Material noch eine Beschichtung des Materials und/oder einen Kern oder eine andere Komponente aufweist.

Der Draht oder das Band bestehen bevorzugt zumindest zu 90 Gew% aus dem Material, besonders bevorzugt zu 100 Gew% aus dem Material.

Das Material ist ein Verbundwerkstoff, insbesondere ein Metallmatrix-Verbundwerkstoff. Daher kann das Material ohne weiteres auch als Verbundwerkstoff oder eben bevorzugt auch als Metallmatrix-Verbundwerkstoff bezeichnet werden.

Eine zusammenhängende Struktur oder genauer eine in sich zusammenhängende Struktur entspricht einer kontinuierlichen Struktur und kann analog zu Emulsionen auch als äußere Phase bezeichnet werden.

Vorzugsweise sind die Bornitrid-Nanoröhren in die Matrix eingebettet. Die Bornitrid-Nanoröhren bilden also analog zu Emulsionen eine innere Phase, die auch als disperse Phase bezeichnet werden kann.

Es kann vorgesehen sein, dass jeder Würfel des Materials mit einer Kantenlänge von einem µm mit jedem anderen Würfel des Materials mit einer Kantenlänge von einem µm über die Matrix metallisch leitend verbunden ist.

Bei erfindungsgemäßen Drähten und Bändern kann vorgesehen sein, dass die Matrix aus einer ausscheidungsgehärteten Legierung besteht.

Hierdurch wird eine zusätzliche Härtung des Drahts oder des Bands erreicht. Die Härtung durch die Ausscheidungen weicht zudem von der Härtung ab, die die Bornitrid-Nanoröhren bewirken.

Ferner kann vorgesehen sein, dass die Bornitrid-Nanoröhren in der Matrix verteilt sind oder gleichmäßig verteilt sind, wobei vorzugsweise die Ausrichtung der Bornitrid-Nanoröhren statistisch gleichmäßig verteilt ist oder die Bornitrid-Nanoröhren in Richtung der Zylinderachse des Drahts oder der Längsrichtung des Bands ausgerichtet sind.

Durch die Verteilung der Bornitrid-Nanoröhren in der Matrix erhält man einen Draht oder ein Band mit homogenen Eigenschaften und hoher Festigkeit bei gleichzeitig guter elektrischer Leitfähigkeit und thermischer Stabilität. Bei einer Ausrichtung der Bornitrid-Nanoröhren in Richtung der Zylinderachse des Drahts oder der Längsrichtung des Bands wird eine axiale mechanische Stabilisierung des Drahts oder des Bands (dort möglich in Längsrichtung oder in Querrichtung) erreicht und dadurch ein Brechen von aus dem Draht oder dem Band hergestellten Prüfnadeln oder Schleifkontakten vermieden. Die Ausrichtung der Bornitrid-Nanoröhren kann beispielsweise dadurch erreicht werden, dass lange Fäden der Bornitrid-Nanoröhren in einer Vorzugsrichtung in das die Matrix bildende Metall beziehungsweise die die Matrix bildende Legierung eingebracht wird. Es sind aber auch andere Möglichkeiten zur Ausrichtung der Bornitrid-Nanoröhren in der Matrix vorstellbar, beispielsweise die Ausrichtung mit einem elektromagnetischen Feld oder durch eine geeignete Strömung einer die Matrix bildenden Schmelze.

Des Weiteren kann vorgesehen sein, dass zwischen 0,1 Gew% und 25 Gew% Bornitrid-Nanoröhren in der Matrix enthalten sind, bevorzugt zwischen 0,5 Gew% und 10 Gew% Bornitrid-Nanoröhren in der Matrix enthalten sind, besonders bevorzugt zwischen 1 Gew% und 5 Gew% Bornitrid-Nanoröhren in der Matrix enthalten sind.

Mit diesen Anteilen von Bornitrid-Nanoröhren in der Matrix kann eine zusammenhängende Matrix der Metalle erreicht werden, so dass die elektrische Leitfähigkeit in dem Draht oder in dem Band von der Matrix bestimmt wird.

Bevorzugt kann vorgesehen sein, dass das Material aus der Matrix und den Bornitrid-Nanoröhren besteht.

Hierdurch wird klargestellt, dass der Draht oder das Band keine weiteren Bestandteile benötigt. Zudem kann so sichergestellt werden, dass die elektrische Leitfähigkeit des Drahts oder des Bands hoch ist und auch die Wärmeleitung durch das Material nicht durch weitere Bestandteile beeinträchtigt wird.

Es kann vorgesehen sein, dass der Draht oder das Band bei Raumtemperatur ein E-Modul m_{E} von mindestens 130 GPa aufweist, bevorzugt von mindestens 170 GPa aufweist, besonders bevorzugt von 210 GPa aufweist.

Auch kann vorgesehen sein, dass der Draht oder das Band bei Raumtemperatur eine 0,2%-Dehngrenze Rp_{0,2} (Elastizitätsgrenze) von mindestens 1000 MPa aufweist, bevorzugt von mindestens 1200 MPa aufweist, besonders bevorzugt von 1500 MPa aufweist.

Ferner kann vorgesehen sein, dass der Draht oder das Band bei Raumtemperatur eine elektrische Leitfähigkeit von mindestens 40% IACS aufweist, bevorzugt von mindestens 50% IACS aufweist, besonders bevorzugt von 57% IACS aufweist.

Durch diese mechanischen und elektrischen Eigenschaften und insbesondere durch deren Kombination wird sichergestellt, dass der Draht oder das Band besonders gute elastische Eigenschaften und eine hohe elektrische Leitfähigkeit hat, um diesen als Prüfnadel oder Schleifkontakt einsetzen zu können.

Das E-Modul m_{E} und die 0,2%-Dehngrenze Rp_{0,2} können mit einer Zwick Zugprüfmaschine Z250 bestimmt werden. Der Zugversuch kann an einem Draht mit 55 µm Drahtdurchmesser erfolgen und die Werte beziehen sich hierauf. Die Prüfgeschwindigkeit bezüglich des E-Moduls m_{E} und der Streckgrenze Rp_{0,2} kann mit 1 mm/min erfolgen.

Die elektrische Leitfähigkeit kann mit einer 4-Pol Messung des Spannungsabfalls an einem Prüfling aus dem Draht oder Band bei definierter Länge mit einem Burster Resistomat 2316 bestimmt werden. Die Messung kann an einem Draht mit einer Drahtlänge zwischen 0,06 m und 0,07 m, einem Durchmesser von 52 µm und einem Messstrom von 10 mA erfolgen.

Des Weiteren kann vorgesehen sein, dass der Draht einen Durchmesser oder das Band eine Dicke von maximal 200 µm aufweisen, bevorzugt einen Durchmesser oder eine Dicke zwischen 10 µm und 100 µm aufweisen, ganz besonders bevorzugt einen Durchmesser oder eine Dicke zwischen 20 µm und 70 µm aufweisen.

Drähte mit diesen Durchmessern beziehungsweise Bänder mit diesen Dicken sind besonders gut als Prüfnadeln und als Schleifdrähte einsetzbar. Die Dicke des Bands ist die schmalste Abmessung des Bands. Das Band ist also breiter als dick und länger als breit.

Gemäß einer bevorzugten Ausführung kann vorgesehen sein, dass die Matrix aus einer Kupfer-Silber-Legierung oder aus einer Palladium-Silber-Legierung besteht, vorzugsweise aus einer Kupfer-Silber-Legierung mit 7 Gew% Silber und dem Rest Kupfer einschließlich herstellungsbedingter Verunreinigungen.

Diese Legierungen sind aufgrund ihrer hohen elektrischen Leitfähigkeit bei gleichzeitig hoher mechanischer Belastbarkeit besonders gut als Metallmatrix für Prüfnadeln oder Schleifdrähte einsetzbar. Typische Materialien für Prüfnadeln sind ausscheidungsgehärtete Palladium-Silber-Legierungen, die 10% Gold und 10% Platin enthalten und beispielsweise unter den Produktnamen Paliney® 7 und Hera 648 vertrieben werden.

Bevorzugt kann vorgesehen sein, dass die Matrix durch Sintern und/oder Pressen aus einem Pulver aus Kupfer, Aluminium, Palladium, Rhodium oder aus einer Kupfer-Basis-Legierung, Aluminium-Basis-Legierung, Palladium-Basis-Legierung oder Rhodium-Basis-Legierung gefertigt ist.

Hierdurch kann die Matrix bei niedrigen Temperaturen erzeugt werden, so dass die Bornitrid-Nanoröhren nicht thermisch zerstört werden.

Es kann vorgesehen sein, dass die Bornitrid-Nanoröhren zumindest 0,5 µm lang sind, bevorzugt zwischen 0,5 µm und 250 µm lang sind, besonders bevorzugt zwischen 1 µm und 200 µm lang sind, ganz besonders bevorzugt zwischen 5 µm und 200 µm lang sind.

Auch kann vorgesehen sein, dass die Bornitrid-Nanoröhren eine mittlere Länge zwischen 1 µm und 200 µm aufweisen, bevorzugt eine mittlere Länge zwischen 10 µm und 200 µm aufweisen und/oder

Ferner kann vorgesehen sein, dass die Bornitrid-Nanoröhren einen Durchmesser von maximal 50 nm aufweisen, bevorzugt einen Durchmesser zwischen 1 nm und 50 nm aufweisen, besonders bevorzugt einen Durchmesser zwischen 2 nm und 10 nm aufweisen, ganz besonders bevorzugt einen Durchmesser zwischen 4 nm und 6 nm aufweisen.

Bornitrid-Nanoröhren mit diesen Abmessungen bewirken eine hohe mechanische Stabilisierung des Materials beziehungsweise des Drahts oder Bands.

Bevorzugt kann vorgesehen sein, dass die Bornitrid-Nanoröhren ein Aspektverhältnis von mindestens 100 aufweisen, bevorzugt ein Aspektverhältnis von mindestens 500 aufweisen, besonders bevorzugt ein Aspektverhältnis von mindestens 1000 aufweisen.

Unter dem Aspektverhältnis wird das Verhältnis zwischen der mittleren Länge der Bornitrid-Nanoröhren und dem (mittleren) Durchmesser der Bornitrid-Nanoröhren verstanden.

Durch die relativ großen Aspektverhältnisse wird eine höhere mechanische Stabilität des Materials beziehungsweise Drahts oder des Bands bewirkt.

Die der vorliegenden Erfindung zugrundeliegenden Aufgaben werden auch gelöst durch ein Verfahren zur Herstellung eines Drahts oder eines Bands mit den folgenden chronologischen Schritten
A) Bereitstellen oder Herstellen eines Pulvers aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen,
B) Vermischen des Pulvers mit Bornitrid-Nanoröhren zu einem Gemisch, und
C) Verbinden des Pulvers des Gemischs zu einer Matrix, in der die Bornitrid-Nanoröhren enthalten sind, so dass ein Material mit der Matrix und mit der Matrix verbundenen Bornitrid-Nanoröhren entsteht, wobei entweder das Material direkt in Form des Drahts oder Bands erzeugt wird oder nach dem Verbinden des Pulvers der Draht oder das Band aus dem so entstandenen Material hergestellt wird.

Diese Herstellungsverfahren werden vor allem dann bevorzugt, wenn das für die Herstellung der Matrix verwendete Metall oder die für die Herstellung der Matrix verwendete Legierung einen hohen Schmelzpunkt (über 700 °C) aufweist.

Es kann bei erfindungsgemäßen Verfahren vorgesehen sein, dass ein erfindungsgemäßer Draht oder ein erfindungsgemäßes Band mit dem Verfahren hergestellt wird.

Ferner kann vorgesehen sein, dass in Schritt C) das Verbinden des Pulvers des Gemischs durch Sintern, Lasersintern, Pressen, Kaltpressen, Heiß-Isostatisches Pressen, Laserschmelzen, Zonen-Schmelzen, Laser-Zonen-Schmelzen, Induktionsschmelzen oder Induktionszonenschmelzen erfolgt.

Beispielsweise kann ein 3D-Druckverfahren mit Lasersintern oder Laserschmelzen zum Verbinden des Pulvers des Gemischs verwendet werden.

Mit diesen Verfahren lässt sich das Material gut und teilweise auch kostengünstig herstellen und die Matrix fügen. Bei vielen der Verfahren kann zudem verhindert werden, dass die Bornitrid-Nanoröhren durch Überhitzung zerstört oder zu stark beeinträchtigt werden, selbst wenn die Metallmatrix einen hohen Schmelzpunkt hat.

Des Weiteren kann vorgesehen sein, dass die Bornitrid-Nanoröhren vor dem Vermischen mit dem Pulver als eine Suspension mit einer Flüssigkeit vorliegen oder eine solche Suspension aus den Bornitrid-Nanoröhren und einer Flüssigkeit hergestellt wird, vorzugsweise als eine Suspension der Bornitrid-Nanoröhren in Ethanol, einer wässrigen Lösung aus Tensiden oder einer wässrigen Lösung aus amphiphilen Poloxameren vorliegen, wobei in Schritt B) das Pulver mit der Suspension vermischt wird.

Hierdurch werden eine gute Durchmischung und Verteilung der Bornitrid-Nanoröhren in dem Pulver für die Matrix erreicht und eine Verklumpung der Bornitrid-Nanoröhren verhindert. Geeignete Verfahren zur Dispersion von Bornitrid-Nanoröhren sind beispielsweise aus dem Artikel "Dispersion of Boron Nitride Nanotubes by Pluronic Triblock Copolymer in Aqueous Solution" S. Wong et al. in Polymers 2019, 11 582 bekannt. Die dort beschriebenen Verfahren können bei erfindungsgemäßen Verfahren zur Herstellung der Suspension mit Bornitrid-Nanoröhren Anwendung finden.

Dabei kann vorgesehen sein, dass die Suspension hergestellt wird, indem pulverförmige Bornitrid-Nanoröhren mit der Flüssigkeit unter Einwirkung von Ultraschall gemischt werden.

Hierdurch können eventuell in der Suspension enthaltene Knäule und Verklumpungen der Bornitrid-Nanoröhren aufgelöst werden.

Die der vorliegenden Erfindung zugrundeliegenden Aufgaben werden des Weiteren gelöst durch ein Verfahren zur Herstellung eines Drahts oder eines Bands, mit den folgenden Schritten
A) Herstellen einer Metallschmelze aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen,
B) Einbringen von Bornitrid-Nanoröhren in die Metallschmelze, und
C) Erstarren der Metallschmelze zu einer Matrix, in der die Bornitrid-Nanoröhren enthalten sind, so dass ein Material mit einer Matrix und den Bornitrid-Nanoröhren entsteht, wobei entweder das Material direkt in Form des Drahts oder Bands aus der Metallschmelze erzeugt wird oder nach dem Erstarren der Draht oder das Band aus dem so hergestellten Material hergestellt wird. Auch bei diesem Verfahren kann vorgesehen sein, dass ein erfindungsgemäßer Draht oder ein erfindungsgemäßes Band mit dem Verfahren hergestellt wird.

Diese Herstellungsverfahren werden vor allem dann bevorzugt, wenn das für die Herstellung der Matrix verwendete Metall oder die für die Herstellung der Matrix verwendete Legierung einen niedrigen Schmelzpunkt (unter 700 °C) aufweist.

Dabei kann vorgesehen sein, dass die Einbringung der Bornitrid-Nanoröhren in Schritt B) durch Infiltration zumindest eines Bornitrid-Nanoröhren-Garns in die Metallschmelze erfolgt.

Hierdurch kann eine Vorzugsrichtung der Bornitrid-Nanoröhren in der Matrix erzeugt werden. Ferner kann so ein gleichmäßiger Eintrag der Bornitrid-Nanoröhren in die Metallschmelze sichergestellt werden.

Bei allen erfindungsgemäßen Verfahren kann vorgesehen sein, dass der Draht oder das Band durch Walzen, Ziehen und/oder Strangpressen oder ähnlichen Verfahren aus dem Material hergestellt wird, wobei vorzugsweise die Herstellung des Drahts oder Bands aus dem Material bei Temperaturen von zwischen 400 °C und 900 °C erfolgt, besonders bevorzugt zwischen 500 °C und 800 °C erfolgt.

Hiermit wird das Material des Drahts oder Bands weiter verfestigt und die Bornitrid-Nanoröhren in der Matrix nicht beeinträchtigt, neu ausgerichtet oder segregiert.

Es kann bei allen erfindungsgemäßen Verfahren vorgesehen sein, dass bei der Herstellung des Verbunds Temperaturen von über 400 °C eingesetzt werden, bevorzugt Temperaturen zwischen 400 °C und 900 °C, besonders bevorzugt zwischen 500 °C und 800 °C.

Die der vorliegenden Erfindung zugrundeliegenden Aufgaben werden auch gelöst durch eine Prüfnadel oder Schleifdraht zumindest bereichsweise bestehend aus zumindest einem Teilstück eines erfindungsgemäßen Drahts oder Bands oder bestehend aus zumindest einem Teilstück eines Drahts oder Bands, der oder das mit einem erfindungsgemäßen Verfahren hergestellt wurde, wobei vorzugsweise das zumindest eine Teilstück senkrecht zur Zylinderachse des Drahts oder senkrecht zu einer Längsachse des Bands gebogen ist.

Die der vorliegenden Erfindung zugrundeliegenden Aufgaben werden auch gelöst durch ein Prüfnadelarray aufweisend mehrere solche zueinander beabstandete Prüfnadeln.

Die der vorliegenden Erfindung zugrundeliegenden Aufgaben werden schließlich auch gelöst durch einen Schleifkontakt aufweisend mehrere kurze erfindungsgemäße Drähte oder Bänder oder mehrere Teilstücke eines erfindungsgemäßen Drahts oder Bands oder aufweisend mehrere Teilstücke eines Drahts oder Bands, der oder das mit einem erfindungsgemäßen Verfahren hergestellt wurde, oder mehrere kurze Drähte oder Bänder, die mit einem erfindungsgemäßen Verfahren hergestellt wurden, wobei vorzugsweise die Drähte, Bänder oder Teilstücke ein Bündel bilden.

Die Prüfnadel, das Prüfnadelarray, der Schleifdraht und der Schleifkontakt profitieren von den guten physikalischen Eigenschaftskombinationen der erfindungsgemäßen beziehungsweise erfindungsgemäß hergestellten Drähte und Bänder, die von der Verbindung der Matrix mit der hohen metallischen elektrischen Leitfähigkeit mit den das Material mechanisch stabilisierenden Bornitrid-Nanoröhren verursacht wird.

Der Erfindung liegt die überraschende Erkenntnis zugrunde, dass es durch die Einlagerung von Bornitrid-Nanoröhren in einer metallischen Matrix geeigneter Metalle und Metall-Legierungen gelingt, Drähte und Bänder zu fertigen, die aufgrund der hohen elektrischen und thermischen Leitfähigkeit durch die Matrix bei gleichzeitig guten elastischen Eigenschaften aufgrund des Verbunds mit den Bornitrid-Nanoröhren zur Herstellung von Prüfnadeln und Schleifdrähten mit besonders guten elektrischen und mechanischen Eigenschaften für Prüfnadeln und Schleifkontakte geeignet sind. Die aus dem Draht oder dem Band gefertigten Prüfnadeln habe gute Federeigenschaften bei gleichzeitig hoher elektrischer und thermischer Leitfähigkeit. Für aus dem Draht oder dem Band gefertigten Schleifdrähte gilt das Gleiche. Mit derartigen Prüfnadeln bestückte Prüfnadelarrays und mit derartigen Schleifdrähten aufgebaute Schleifkontakte sind daher lange einsetzbar, wobei gleichzeitig eine hohe Messgenauigkeit der Prüfnadelarrays beziehungsweise eine geringe Verlustleistung des Schleifkontakts ermöglicht wird.

Überraschend wurde dabei gefunden, dass wider Erwarten eine metallische Matrix mit Kohlenstoff-Nanoröhren für die Anwendung als Prüfnadeln und Schleifdrähte weniger gut zum Aufbau des Verbundwerkstoffs für diese Anwendungen geeignet ist, obwohl die Kohlenstoff-Nanoröhren eine deutlich höhere elektrische Leitfähigkeit aufweisen als Bornitrid-Nanoröhren. Der Grund ist hierbei in der höheren thermischen Beständigkeit der Bornitrid-Nanoröhren in der Metall-Matrix zu sehen und zusätzlich darin, dass die elektrische Leitfähigkeit der metallischen Matrix die elektrische Leitfähigkeit des Materials (also des Verbunds) dominiert, sofern die Matrix eine zusammenhängende metallisch leitfähige Struktur aufweist. Es wurde also überraschend gefunden, dass unter dieser Bedingung das Material (also der Verbund) aus metallischer Matrix und Bornitrid-Nanoröhren für Prüfnadeln und Schleifdrähten für Schleifkontakte eine bessere Kombination physikalischer Eigenschaften birgt als eine metallische Matrix mit Kohlenstoff-Nanoröhren. Die Kohlenstoff-Nanoröhren zersetzen sich zudem in der Matrix bereits bei relativ geringen Temperaturen unter 400 °C. Dies gilt insbesondere für die Prozessierung des Materials, so dass eine Herstellung stark erschwert wird und sich gegebenenfalls nicht mehr wirtschaftlich gestalten lässt. Des Weiteren können sich bei hohen elektrischen Leistungen Nachteile ergeben, da sich dann die bessere thermische strukturelle Stabilität der Bornitrid-Nanoröhren in der Matrix gegenüber der von Kohlenstoff-Nanoröhren auswirkt.

Eine Verstärkung mit Kohlenstoff-Nanoröhren hat also den Nachteil, dass die Kohlenstoff-Nanoröhren eine geringe thermische Stabilität aufweisen, wobei sich die Kohlenstoff-Nanoröhren bereits bei Temperaturen um 400 °C zersetzen und ihre verstärkende Wirkung in einem Verbundwerkstoff einbüßen, wohingegen Bornitrid-Nanoröhren bis zu Temperaturen von 900 °C stabil sind. Dieser Unterschied ist sowohl für die Prozessierung des Materials, als auch in der Anwendung, von hohem Nutzen. Aufgrund ihrer ausgezeichneten mechanischen Eigenschaften, in Kombination mit ihrer chemischen Inertheit und ausgezeichneter Wärmeleitfähigkeit (verbesserte Abfuhr von Prozesswärme, dadurch indirekte Verbesserung der Warmfestigkeit), ist eine mechanische Verstärkung von zum Beispiel Kupfer und Kupferlegierungen (oder anderen Metallen und Legierungen, welche für Kontaktanwendungen geeignet sind) mit Bornitrid-Nanoröhren von großem Vorteil für Kontaktanwendungen. Die Verwendung von Bornitrid-Nanoröhren (BNNT - Bornitridnanotubes) gegenüber Kohlenstoff-Nanoröhren (CNT - Kohlenstoffnanotubes) für Kontaktanwendungen ist insbesondere deshalb überraschend, weil Bornitrid-Nanoröhren elektrische Isolatoren sind. Erst durch die höhere thermische Stabilität kann der Einsatz von Bornitrid-Nanoröhren gegenüber Kohlenstoff-Nanoröhren sogar bei elektrischen Anwendungen vorteilhaft sein.

Ein Vorteil einer BNNT-Verstärkung gegenüber ausscheidungshärtenden Legierungen ist die fehlende "atomare Mischbarkeit" von BNNT und der zu verstärkenden Matrix, so dass der negative Einfluss auf die elektrischen Eigenschaften des Verbundwerkstoffs geringer ausfällt als bei ausscheidungshärtenden Legierungen. Aufgrund des Einflusses der Entropie auf die Mischbarkeit zweier Stoffe existiert immer eine von Null verschiedene Löslichkeit von einem Stoff B in einem Stoff A, auch wenn diese sehr gering und der resultierende Einfluss auf die physikalischen Eigenschaften ebenfalls gering ausfallen kann. Neben dieser thermodynamischen Barriere existiert zusätzlich eine in der Realität häufig wesentlich signifikantere kinetische Barriere, welche dafür sorgen kann, dass sich ein solches System dauerhaft in einem Nichtgleichgewichtszustand befinden kann, so dass ein Teil des Stoffs B in Stoff A gelöst bleibt (also nicht ausscheidet) und die elektrischen Eigenschaften negativ beeinflussen kann.

Die vorliegende Erfindung zielt darauf ab eine Kupferbasislegierung (oder andere gängige Kontaktwerkstoffe) mit Hilfe von Bornitrid-Nanoröhren mechanisch zu verstärken, so dass hohe Festigkeiten erreicht werden können, ohne dabei die elektrische Leitfähigkeit zu sehr zu reduzieren. Durch die hohe thermische Stabilität von Bornitrid-Nanoröhren sind ganz allgemein Kontaktanwendungen bei Temperaturen von bis zu einigen 100°C denkbar (die thermische Stabilität ist ein wesentliches Unterscheidungsmerkmal zu Kohlenstoff-Nanoröhren), welche sich nicht auf die Halbleiterindustrie beschränken. Der Bornitrid-Nanoröhren-Kupfer-Verbundwerkstoff kann durch Kaltpressen und Sintern, Heiß-Isostatisches-Pressen oder ähnliche Verfahren hergestellt werden, mit denen ein nahezu dichter Volumenkörper hergestellt werden kann.

Der pulvermetallurgische Verbundwerkstoff (also das Material des Drahts oder des Bands) kann zunächst durch Kugelmahlen von Pulver des entsprechenden Metalls oder der entsprechenden Legierung und einer Suspension aus BNNT hergestellt werden. Das Pulvermahlen erfolgt sowohl zur Durchmischung von Pulver und Suspension als auch zur mechanischen Kornfeinung der verwendeten Legierung und Einarbeitung der BNNT in die Matrix auf einer Längenskala, die dazu geeignet ist, ein effizientes Hindernis für Versetzungsbewegung in dem herzustellenden Material beziehungsweise in dem Metallmatrix-Verbundwerkstoff darzustellen, so die Festigkeit zu erhöhen und einen messbaren Beitrag zur Wärmeabfuhr zu leisten. Die BNNT-Suspension wird hergestellt indem ein BNNT-Pulver in eine Ethanol-Lösung gegeben und in einem Ultraschallbad behandelt wird. Zur Besserung "Entzerrung" der BNNT (um eine "Knäuelbildung" zu vermeiden beziehungsweise um vorhandene Knäuel zu entzerren) kann statt Ethanol auch zum Beispiel eine Lösung aus amphiphilen Poloxameren (nichtionischen Tensiden) verwendet werden.

Die weitere Verarbeitung zu einem Draht oder einem Band kann durch Walzen, Ziehen und/oder Strangpressen oder ähnliches auch bei niedrigen Temperaturen (unter 400 °C) erfolgen.

Aufgrund der hohen thermischen Stabilität der BNNT ist für einige niedrigschmelzende Legierungen sogar ein schmelzmetallurgischer Prozess denkbar. Bevorzugt kann dazu ein Induktionsschmelzen eingesetzt werden, um eine Durchmischung des Metalls oder der Metalllegierung zu gewährleisten, da die BNNT aufgrund ihrer geringen Dichte in der Metallschmelze aufschwimmen könnten. Andere Verfahren könnten eine Infiltration eines BNNT-Garns mit einer Metallschmelze darstellen, so wie das in der WO 2018/126191 A1 vorgeschlagen ist.

Vorteilhaft sind die erfindungsgemäßen Drähte, Bänder und Verfahren zu deren Herstellung für die Anwendung in Prüfnadeln und Schleifdrähte also dadurch, dass eine höhere thermische Stabilität im Vergleich mit Kohlenstoff-Nanoröhren erreicht werden kann, was sich vorteilhaft sowohl auf die Produkteigenschaften als auch auf den Herstellungsprozess auswirkt. Die gesteigerte Festigkeit, ohne dabei große Einbußen in der elektrischen Leitfähigkeit hinnehmen zu müssen, bei gleichzeitig sehr guter Wärmeleitfähigkeit, machen die erfindungsgemäßen beziehungsweise erfindungsgemäß hergestellten Drähte und Bänder sowie die daraus gefertigten Prüfnadeln, Prüfnadelarrays, Schleifdrähte und Schleifkontakte, wie Schleifringe und Vieldrahtschleifer, vorteilhaft gegenüber aus dem Stand der Technik bekannten Drähten und Bänder für Kontaktanwendungen, wie bei Schleifringübertragern, Prüfnadeln und Mikroschaltern.

Im Folgenden werden Ausführungsbeispiele der Erfindung anhand von drei Figuren erläutert, ohne jedoch dabei die Erfindung zu beschränken. Dabei zeigt:
Figur 1: eine schematische perspektivische Querschnittansicht auf einen erfindungsgemäßen Draht;
Figur 2: eine schematische perspektivische Querschnittansicht auf ein erfindungsgemäßes Band; und
Figur 3: den Ablauf eines beispielhaften erfindungsgemäßen Verfahrens als Flussdiagramm.

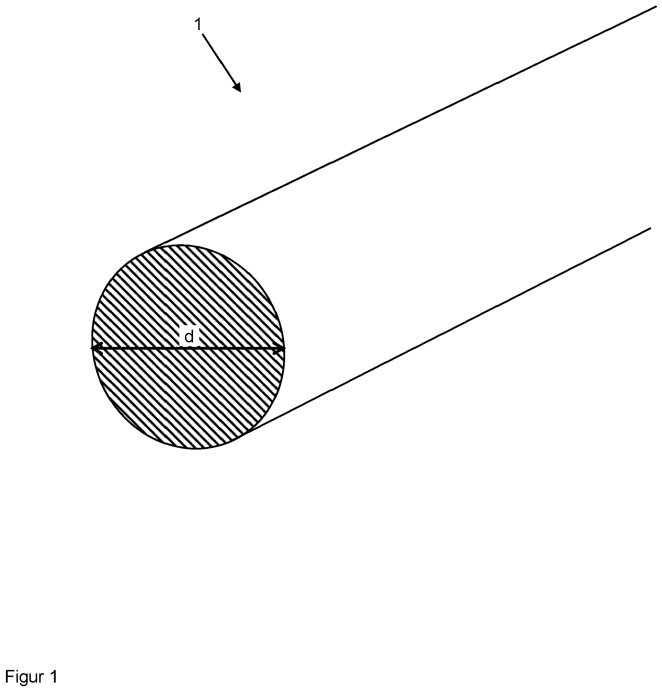

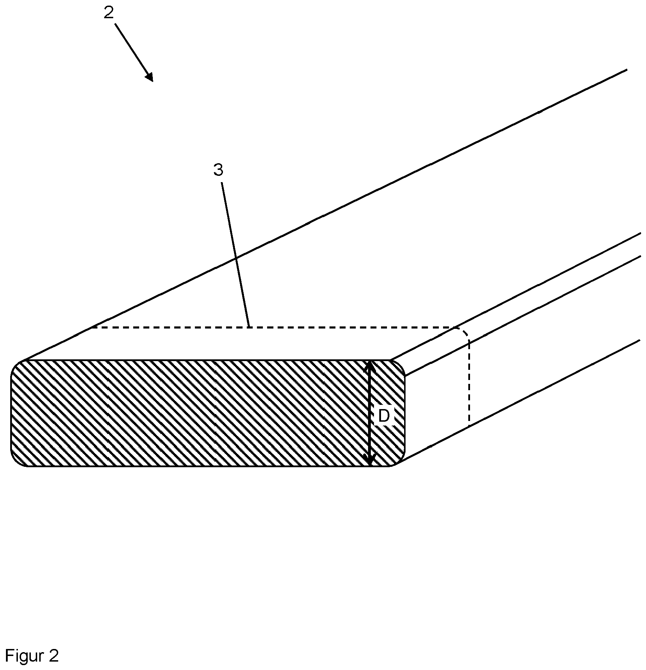

Figur 1 zeigt eine schematische, perspektivische Querschnittansicht auf einen erfindungsgemäßen Draht 1. Der Draht 1 kann einen zylindersymmetrischen Aufbau haben. Figur 2 zeigt eine schematische perspektivische Querschnittansicht auf ein erfindungsgemäßes Band 2, das einen rechteckigen Querschnitt mit abgerundeten Ecken haben kann. Der Draht 1 und das Band 2 bestehen aus einem Material in Form eines Metallmatrix-Verbundwerkstoffs mit einer zusammenhängenden Matrix aus einem Metall oder einer Metalllegierung, wie beispielsweise aus Kupfer oder einer Kupfer-Basislegierung wie CuAg7, also Kupfer mit 7 Gew% Ag (alles einschließlich herstellungsbedingter Verunreinigungen), und aus gleichmäßig verteilten Bornitrid-Nanoröhren, die vorzugsweise keine bestimmte Vorzugsausrichtung aufweisen. Das Material kann zu 95 Gew% bis 99 Gew% aus dem Metall, der Metalllegierung oder aus Kupfer oder der Kupfer-Basis-Legierung und zu 1 Gew% bis 5 Gew% aus den Bornitrid-Nanoröhren bestehen. Dadurch sind die Bornitrid-Nanoröhren in der metallisch leitfähigen Matrix eingeschlossen und fest mit der Matrix verbunden, so dass sie in der Lage sind, mechanische Spannungen aus der Matrix aufzunehmen. Die Bornitrid-Nanoröhren bewirken so eine mechanische Stabilisierung der Matrix, während sie die elektrische Leitfähigkeit der Matrix nur wenig verschlechtern. Ein Optimum wird erreicht, wenn das mathematische Produkt von elektrischer Leitfähigkeit und Festigkeit des Materials ein Maximum ergibt. Dieses Optimum hängt von dem verwendeten Metall beziehungsweise der verwendeten Metalllegierung ebenso ab wie von der Länge der verwendeten Bornitrid-Nanoröhren und muss folglich individuell bestimmt werden. Grundsätzlich liegt das Optimum für unterschiedliche Materialien zwischen 0,1 Gew% und 25 Gew% Bornitrid-Nanoröhren. Neben Kupfer und Kupfer-Basis-Legierungen können auch andere für Kontaktanwendungen geeignete Metalle und Metalllegierungen wie Aluminium, Palladium, Rhodium, Aluminium-Basis-Legierung, Palladium-Basis-Legierung oder Rhodium-Basis-Legierung, einschließlich damit verbundener Verunreinigungen, für die Matrix verwendet werden.

Der Draht 1 und das Band 2 können durch Umformen (Ziehen, Walzen, Strangpressen) und/oder durch Schneiden und gegebenenfalls biegen zu Prüfnadeln oder Schleifdrähten umgeformt werden. Das Band 2 kann dabei auch senkrecht zu dessen Längsachse geschnitten werden, wie dies durch die gestrichelte Linie als Schnittebene 3 in Figur 2 angedeutet ist.

Der Draht 1 kann einen Durchmesser d (siehe Figur 1) von maximal 200 µm aufweisen, bevorzugt zwischen 10 µm und 100 µm. Das Band kann eine Dicke D (siehe Figur 2) von maximal 200 µm aufweisen, bevorzugt zwischen 10 µm und 100 µm.

Die Bornitrid-Nanoröhren können zwischen 0,5 µm und 250 µm lang sein. Ferner können die Bornitrid-Nanoröhren eine mittlere Länge zwischen 1 µm und 200 µm aufweisen. Vorzugsweise haben die Bornitrid-Nanoröhren einen Durchmesser von etwa 5 nm. Die Bornitrid-Nanoröhren können ein Aspektverhältnis von 100 oder mehr aufweisen oder sogar von 1000 oder mehr aufweisen. Unter dem Aspektverhältnis wird das Verhältnis zwischen der mittleren Länge der Bornitrid-Nanoröhren und dem (mittleren) Durchmesser der Bornitrid-Nanoröhren verstanden.

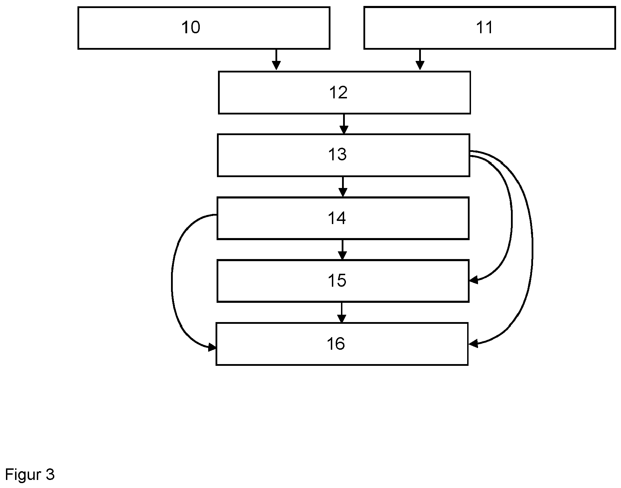

Im Folgenden wird anhand von Figur 3 der Ablauf eines beispielhaften erfindungsgemäßen Verfahrens geschildert.

In einem ersten Arbeitsschritt 10 kann ein metallisches Ausgangsmaterial, wie beispielsweise Kupfer oder eine Kupfer-Basis-Legierung, zu einem Pulver oder einem Granulat gemahlen werden. Alternativ kann auch ein passendes Metall-Pulver oder ein passendes Metall-Granulat bereitgestellt werden.

In einem zweiten Arbeitsschritt 11 kann eine Suspension aus Bohrnitrid-Nanoröhren und einem Lösungsmittel wie Ethanol hergestellt werden. Dabei kann Ultraschall zur Durchmischung und zum Auffalten von Knäulen der Bohrnitrid-Nanoröhren verwendet werden. Der erste Arbeitsschritt 10 und der zweite Arbeitsschritt 11 können in beliebiger Reihenfolge oder auch parallel zueinander erfolgen.

In einem dritten Arbeitsschritt 12 kann das so erhaltene Metall-Pulver oder das Metall-Granulat mit der Suspension aus Bornitrid-Nanoröhren und dem Lösungsmittel gemischt und (weiter) gemahlen werden. Dazu werden bis zu 25 Gew% Bornitrid-Nanoröhren in das Pulver oder das Granulat gemischt. Beim Mischen und Mahlen kann das Lösungsmittel verdampft oder der Mischung auf andere Weise entzogen werden. Das Lösungsmittel sorgt für eine gleichmäßige Verteilung der Bohrnitrid-Nanoröhren in dem Metallpulver. Dabei entsteht ein Gemisch aus dem Metallpulver und den Bohrnitrid-Nanoröhren.

In einem vierten Arbeitsschritt 13 können die metallischen Pulveranteile des Gemischs oder Teile davon durch Sintern, Heiß-Isostatisches Pressen, Kaltpressen oder Laserschmelzen miteinander verbunden werden. Hierbei entsteht eine zusammenhänge metallische Matrix, in der die Bohrnitrid-Nanoröhren verteilt sind.

Das so gewonnene Material kann entweder gleich in der gewünschten Form als Draht 1 (siehe Figur 1) oder Band 2 (siehe Figur 1) vorliegen oder das Material kann nachfolgend umgeformt werden.

In einem optionalen fünften Arbeitsschritt 14 kann das Material zu einem Draht 1 oder einem Band 2 umgeformt werden. Dabei wird das Material nicht aufgeschmolzen. Vorzugsweise erfolgt die Umformung durch Ziehen, Walzen und/oder Strangpressen.

Anschließend kann optional in einem sechsten Arbeitsschritt 15 eine Wärmebehandlung des so erzeugten Drahts 1 oder Bands 2 erfolgen.

Zum Abschluss kann in einem optionalen siebten Arbeitsschritt 16 der Draht 1 oder das Band 2 zu Prüfnadeln oder Schleifdrähten geschnitten, gestanzt oder anders gestückelt werden. Auch hierbei erfolgt die Teilung ohne Schmelzvorgang.

Die in der voranstehenden Beschreibung sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1: Draht
- 2: Band
- 3: Schnittebene
- 10: erster Arbeitsschritt
- 11: zweiter Arbeitsschritt
- 12: dritter Arbeitsschritt
- 13: vierter Arbeitsschritt
- 14: fünfter Arbeitsschritt
- 15: sechster Arbeitsschritt
- 16: siebter Arbeitsschritt
- d: Durchmesser des Drahts
- D: Dicke des Bands

## Patentansprüche

1. Draht (1) oder Band (2) zur Herstellung von Prüfnadeln oder Schleifkontakten, der Draht (1) oder das Band (2) aufweisend ein Material oder bestehend aus einem Material, das Material aufweisend eine Matrix aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen, wobei die Matrix eine zusammenhängende metallisch leitfähige Struktur in dem Material bildet,
**dadurch gekennzeichnet, dass**
Bornitrid-Nanoröhren in der Matrix enthalten sind, wobei die Bornitrid-Nanoröhren ein festes Gefüge mit der Matrix bilden.

2. Draht (1) oder Band (2) nach Anspruch 1, **dadurch gekennzeichnet, dass** die Matrix aus einer ausscheidungsgehärteten Legierung besteht.

3. Draht (1) oder Band (2) nach Anspruch 1 oder 2, **dadurch gekennzeichnet, dass** die Bornitrid-Nanoröhren in der Matrix verteilt sind oder gleichmäßig verteilt sind, wobei vorzugsweise die Ausrichtung der Bornitrid-Nanoröhren statistisch gleichmäßig verteilt ist oder die Bornitrid-Nanoröhren in Richtung der Zylinderachse des Drahts (1) oder der Längsrichtung des Bands (2) ausgerichtet sind.

4. Draht (1) oder Band (2) nach einem der vorangehenden Ansprüche, **dadurch gekennzeichnet, dass**
zwischen 0,1 Gew% und 25 Gew% Bornitrid-Nanoröhren in der Matrix enthalten sind, bevorzugt zwischen 0,5 Gew% und 10 Gew% Bornitrid-Nanoröhren in der Matrix enthalten sind, besonders bevorzugt zwischen 1 Gew% und 5 Gew% Bornitrid-Nanoröhren in der Matrix enthalten sind und/oder
das Material aus der Matrix und den Bornitrid-Nanoröhren besteht.

5. Draht (1) oder Band (2) nach einem der vorangehenden Ansprüche, **dadurch gekennzeichnet, dass**
der Draht (1) oder das Band (2) bei Raumtemperatur ein E-Modul m_{E} von mindestens 130 GPa aufweist, bevorzugt von mindestens 170 GPa aufweist, besonders bevorzugt von 210 GPa aufweist, und/oder
der Draht (1) oder das Band (2) bei Raumtemperatur eine 0,2%-Dehngrenze Rp_{0,2} (Elastizitätsgrenze) von mindestens 1000 MPa aufweist, bevorzugt von mindestens 1200 MPa aufweist, besonders bevorzugt von 1500 MPa aufweist, und/oder
der Draht (1) oder das Band (2) bei Raumtemperatur eine elektrische Leitfähigkeit von mindestens 40% IACS aufweist, bevorzugt von mindestens 50% IACS aufweist, besonders bevorzugt von 57% IACS aufweist.

6. Draht (1) oder Band (2) nach einem der vorangehenden Ansprüche, **dadurch gekennzeichnet, dass**
der Draht (1) einen Durchmesser (d) oder das Band (2) eine Dicke (D) von maximal 200 µm aufweisen, bevorzugt einen Durchmesser (d) oder eine Dicke (D) zwischen 10 µm und 100 µm aufweisen, ganz besonders bevorzugt einen Durchmesser (d) oder eine Dicke (D) zwischen 20 µm und 70 µm aufweisen, und/oder
die Matrix aus einer Kupfer-Silber-Legierung oder aus einer Palladium-Silber-Legierung besteht, vorzugsweise aus einer Kupfer-Silber-Legierung mit 7 Gew% Silber und dem Rest Kupfer einschließlich herstellungsbedingter Verunreinigungen.

7. Draht (1) oder Band (2) nach einem der vorangehenden Ansprüche, **dadurch gekennzeichnet, dass**
die Matrix durch Sintern und/oder Pressen aus einem Pulver aus Kupfer, Aluminium, Palladium, Rhodium oder aus einer Kupfer-Basis-Legierung, Aluminium-Basis-Legierung, Palladium-Basis-Legierung oder Rhodium-Basis-Legierung gefertigt ist, und/oder
die Bornitrid-Nanoröhren ein Aspektverhältnis von mindestens 100 aufweisen, bevorzugt ein Aspektverhältnis von mindestens 500 aufweisen, besonders bevorzugt ein Aspektverhältnis von mindestens 1000 aufweisen.

8. Draht (1) oder Band (2) nach einem der vorangehenden Ansprüche, **dadurch gekennzeichnet, dass**
die Bornitrid-Nanoröhren zumindest 0,5 µm lang sind, bevorzugt zwischen 0,5 µm und 250 µm lang sind, besonders bevorzugt zwischen 1 µm und 200 µm lang sind, ganz besonders bevorzugt zwischen 5 µm und 200 µm lang sind, und/oder
die Bornitrid-Nanoröhren eine mittlere Länge zwischen 1 µm und 200 µm aufweisen, bevorzugt eine mittlere Länge zwischen 10 µm und 200 µm aufweisen und/oder
die Bornitrid-Nanoröhren einen Durchmesser von maximal 50 nm aufweisen, bevorzugt einen Durchmesser zwischen 1 nm und 50 nm aufweisen, besonders bevorzugt einen Durchmesser zwischen 2 nm und 10 nm aufweisen, ganz besonders bevorzugt einen Durchmesser zwischen 4 nm und 6 nm aufweisen.

9. Verfahren zur Herstellung eines Drahts (1) oder eines Bands (2), insbesondere eines Drahts (1) oder eines Bands (2) nach einem der vorangehenden Ansprüche, **gekennzeichnet durch** die folgenden chronologischen Schritte
A) Bereitstellen oder Herstellen eines Pulvers aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen,
B) Vermischen des Pulvers mit Bornitrid-Nanoröhren zu einem Gemisch, und
C) Verbinden des Pulvers des Gemischs zu einer Matrix, in der die Bornitrid-Nanoröhren enthalten sind, so dass ein Material mit der Matrix und mit der Matrix verbundenen Bornitrid-Nanoröhren entsteht, wobei entweder
das Material direkt in Form des Drahts (1) oder Bands (2) erzeugt wird oder nach dem Verbinden des Pulvers der Draht (1) oder das Band (2) aus dem so entstandenen Material hergestellt wird.

10. Verfahren nach Anspruch 9, **dadurch gekennzeichnet, dass**
in Schritt C) das Verbinden des Pulvers des Gemischs durch Sintern, Lasersintern, Pressen, Kaltpressen, Heiß-Isostatisches Pressen, Laserschmelzen, Zonen-Schmelzen, Laser-Zonen-Schmelzen, Induktionsschmelzen oder Induktionszonenschmelzen erfolgt.

11. Verfahren nach Anspruch 9 oder 10, **dadurch gekennzeichnet, dass**
die Bornitrid-Nanoröhren vor dem Vermischen mit dem Pulver als eine Suspension mit einer Flüssigkeit vorliegen oder eine solche Suspension aus den Bornitrid-Nanoröhren und einer Flüssigkeit hergestellt wird, vorzugsweise als eine Suspension der Bornitrid-Nanoröhren in Ethanol, einer wässrigen Lösung aus Tensiden oder einer wässrigen Lösung aus amphiphilen Poloxameren vorliegen, wobei in Schritt B) das Pulver mit der Suspension vermischt wird,
wobei ebenfalls bevorzugt die Suspension hergestellt wird, indem pulverförmige Bornitrid-Nanoröhren mit der Flüssigkeit unter Einwirkung von Ultraschall gemischt werden.

12. Verfahren zur Herstellung eines Drahts (1) oder eines Bands (2), insbesondere eines Drahts (1) oder eines Bands (2) nach einem der Ansprüche 1 bis 8, **gekennzeichnet durch** die folgenden Schritte
A) Herstellen einer Metallschmelze aus Kupfer, Aluminium, Palladium, Rhodium oder aus einer Kupfer-Basis-Legierung, Aluminium-Basis-Legierung, Palladium-Basis-Legierung oder Rhodium-Basis-Legierung, einschließlich damit verbundener Verunreinigungen,
B) Einbringen von Bornitrid-Nanoröhren in die Metallschmelze, und
C) Erstarren der Metallschmelze zu einer Matrix, in der die Bornitrid-Nanoröhren enthalten sind, so dass ein Material mit einer Matrix und den Bornitrid-Nanoröhren entsteht, wobei entweder
das Material direkt in Form des Drahts (1) oder Bands (2) aus der Metallschmelze erzeugt wird oder
nach dem Erstarren ein der Draht (1) oder das Band (2) aus dem so hergestellten Material hergestellt wird, wobei vorzugsweise
die Bornitrid-Nanoröhren in Schritt B) durch Infiltration zumindest eines Bornitrid-Nanoröhren-Garns in die Metallschmelze erfolgt.

13. Verfahren nach einem der Ansprüche 9 bis 12, **dadurch gekennzeichnet, dass** der Draht (1) oder das Band (2) durch Walzen, Ziehen und/oder Strangpressen oder ähnlichen Verfahren aus dem Material hergestellt wird, wobei vorzugsweise die Herstellung des Drahts (1) oder Bands (2) aus dem Material bei Temperaturen von maximal 400 °C erfolgt.

14. Prüfnadel oder Schleifdraht zumindest bereichsweise bestehend aus zumindest einem Teilstück eines Drahts (1) oder Bands (2) nach einem der Ansprüche 1 bis 8 oder bestehend aus zumindest einem Teilstück eines Drahts (1) oder Bands (2), der oder das mit einem Verfahren nach einem der Ansprüche 9 bis 13 hergestellt wurde, wobei vorzugsweise das zumindest eine Teilstück senkrecht zur Zylinderachse des Drahts (1) oder senkrecht zu einer Längsachse des Bands (2) gebogen ist.

15. Schleifkontakt aufweisend mehrere kurze Drähte oder Bänder nach einem der Ansprüche 1 bis 8 oder mehrere Teilstücke eines Drahts (1) oder Bands (2) nach einem der Ansprüche 1 bis 8 oder aufweisend mehrere Teilstücke eines Drahts (1) oder Bands (2), der oder das mit einem Verfahren nach einem der Ansprüche 9 bis 13 hergestellt wurde, oder mehrere kurze Drähte oder Bänder, die mit einem Verfahren nach einem der Ansprüche 9 bis 13 hergestellt wurden, wobei vorzugsweise die Drähte, Bänder oder Teilstücke ein Bündel bilden.
